# EUROPEAN PATENT SPECIFICATION

(11) **EP 1 131 915 B1**
(45) Date of publication and mention of the grant of the patent: **05.10.2005**
(21) Application number: 99972810.8
(22) Date of filing: 23.11.1999
(51) Int. Cl.: H04L 7/02

(54) **A METHOD AND A CIRCUIT FOR RECOVERING A DIGITAL DATA SIGNAL AND A CLOCK FROM A RECEIVED DATA SIGNAL**
EIN VERFAHREN UND EINE SCHALTUNG ZUR WIEDERGEWINNUNG EINES DIGITALEN SIGNALES UND TAKTES AUS EINEM EMPFANGENEN DATENSIGNAL
PROCEDE ET CIRCUIT DE RECUPERATION D'UN SIGNAL DE DONNEES NUMERIQUES ET D'HORLOGE A PARTIR D'UN SIGNAL DE DONNEES RE U

(30) Priority: 24.11.1998 DK 154398
(43) Date of publication of application: 12.09.2001
(73) Proprietor: Giga A/S, 2740 Skovlunde (DK)
(72) Inventor: FINSETH, Niels, Christian, DK-1955 Frederiksberg (DK)
(74) Representative: Morgan, David James
(86) International application number: PCT/DK1999/000648
(87) International publication number: WO 2000/031914

(56) References cited:
- EP-A1- 0 312 671
- EP-A1- 0 663 744
- GB-A- 2 290 439
- US-A- 3 851 101
- US-A- 3 916 084
- US-A- 4 339 823
- US-A- 5 793 823

## Description

The invention relates to a method for recovering a digital data signal and a clock signal from a received data signal consisting of a number of successive bits, wherein a clock signal is first produced from the received data signal by means of a resonator circuit, and wherein the recovered data signal is produced by sampling the received data signal with the recovered clock signal. In addition, the invention relates to a corresponding circuit.

When receiving rapid digital data signals in the form of a number of successive bits, e.g. from an optical transmission link, a clock signal will typically be recovered from the received data signal and by means of this clock signal the incoming data will be retimed in e.g. a flip-flop which means that the individual bits of the data signal are synkronized with the clock signal. A number of methods for achieving this are known. In an frequently used method the clock signal is recovered or extracted first by producing a signal having a pulse for each shift in the received data signal and then by filtrating this pulse signal through a resonator circuit. The resonator circuit may e.g. comprise an SAW filter or a dielectric high Q filter. One of the advantages of this method is that a very clean and well defined clock signal is achieved. In addition, the method is well-reputed and verified at very high data rates.

At very high data rates, the individual bit periods are, naturally, very short; the bit period at 2.5 Gbit/s is, e.g., only 400 ps. Hence for every bit the received data signal is stable for only a short period, and it is therefore important that the incoming data signal is sampled quite accurately in the centre of the bit period, or in the centre of the eye diagram as it is also termed. Since the temporal characteristics of both the data signal and the clock signal is subjected to variations originating from the transmission link as well as e.g. process and temperature variations, it is difficult to ensure that the synchronisation between them is sufficient for the sampling actually to be effected in the centre of the bit period.

This may be rectified to some extent by inserting an adjustable time delay element in one of the signals. Typically, the data signal will be delayed since the recovered clock signal is already subjected to some delay in e.g. the resonator circuit. However, this solution requires an adjustment of the circuit in question, and since this adjustment is to be carried out separately for each individual circuit during manufacturing, it is a process that, to a substantial extent, makes the product more expensive and more complicated. In addition, it is only possible to account for static variations in this manner whereas dynamic variations, which e.g. may be caused by temperature variations, are not accounted for.

Thus, it is an object of the invention to set out a method of the above type, wherein the sampling in time during which the data signal is stable is automatically ensured, and wherein an individual adjustment of the synchronisation in the preceding circuits is thus avoided.

According to the invention this is achieved by phase locking the received data signal and the recovered clock signal to each other as indicated in the characterising clause of claim 1. By phase locking the two signals to each other immediately before the sampling, the effect of the varying time delays to which the two signals have been subjected on their way through the circuit is neutralised, and every sampling can be performed precisely within the very short time during which the data signal is stable.

As indicted in claim 2, it may be the recovered clock signal which is time delayed depending on the measured phase difference. This provides a very exact time adjustment, and in addition it is advantageous that the time delay only has to be implemented at a single frequency since the clock signal only has a single frequency component.

Alternatively, it may, as indicated in claim 3, be the received data signal which is time delayed depending on the measured phase difference.

The time delay may, as indicated in claim 4, be produced by providing the measured phase difference as steering signal to a controllable delay unit. A relatively simple solution is thus obtained in that the desired effect can be achieved with only one component, i.e. a controllable delay unit.

Alternatively, the time delay may, as indicated in claim 5, be produced by providing the measured phase difference as a further steering signal to a frequency locked loop in which a controlled oscillator produces the recovered clock signal controlled by a signal which is produced as a measure of a frequency variation between the recovered clock signal and an output signal from said resonator circuit. By use of a frequency locked loop for producing the time delayed signal, the latter may generally be produced without jitter, causing the retimed data signal to be largely free of jitter, as well.

As mentioned the invention furthermore provides a circuit for recovering a digital data signal and a clock signal from a received data signal consisting of a number of successive bits, wherein the circuit comprises a resonator circuit for producing a clock signal from the received data signal and is designed to produce the recovered data signal by sampling the received data signal with the recovered clock signal. The circuit is characterised by the features defined in the characterising clause of claim 6. The effect of the varying time delays to which the two signals have been subjected separately on their way through the circuit is neutralised as described above, and each sampling may be performed precisely within the very short time during which the data signal is stable.

As indicated in claim 7, it may be the recovered clock signal which is time delayed depending on the measured phase difference by means comprised by the circuit. This provides a very exact time adjustment, and in addition it is advantageous that the time delay only has to be implemented at a single frequency since the clock signal has only a single frequency component.

Alternatively, it may, as indicated in claim 8, be the received data signal which is time delayed by means comprised by the circuit depending on the measured phase difference.

The circuit may, as indicated in claim 9, comprise a controllable delay unit for producing said time delay controlled by the measured phase difference. A relatively simple solution is thus obtained in that the desired effect can be achieved with only one component, i.e. a controllable delay unit.

Alternatively, the circuit may as indicated in claim 10, comprise af frequency locked loop wherein a controlled oscillator is arranged to produce the recovered clock signal controlled by a signal which is produced as a measure of a frequency variation between the recovered clock signal and an output signal from said resonator circuit, and wherein the frequency locked loop is furthermore designed to produce said time delay by provision of the measured phase difference as a further steering signal to said loop. By use of a frequency locked loop for producing the time delayed signal, the latter may generally be produced without jitter, causing the retimed data signal to be largely free of jitter, as well.

Preferred embodiments of the invention will be described in greater detail below with reference to the drawings in which:
Fig.1 shows a known circuit for recovering a digital data signal and a clock signal from a received data signal;
Fig. 2 shows a first embodiment of a circuit according to the invention;
Fig. 3 shows an example of the structure of a phase detector for use in the circuit of Fig. 2;
Fig. 4 shows a second embodiment of a circuit according to the invention; and
Fig. 5 shows a third embodiment of a circuit according to the invention.

The disclosed circuits hereunder are preferably integrated on a single or several integrated circuits. To support the required high-speed operation of the present circuits, logic gates and circuit blocks are preferably implemented as CML logic using bipolar transistors. The preferred process is a 2.0µm Bipolar process suitable digital circuits operating within the frequency range of about 622 MHz to 10 GHz. The NPN transistors provided by this process have f_{T} values of about 25 GHz. Alternatively, commercially available 0.13 - 0.25 µm CMOS processes with sufficiently fast transistors may be capable of being applied in some applications of the present invention, at least for circuits operating at the lower system frequencies.

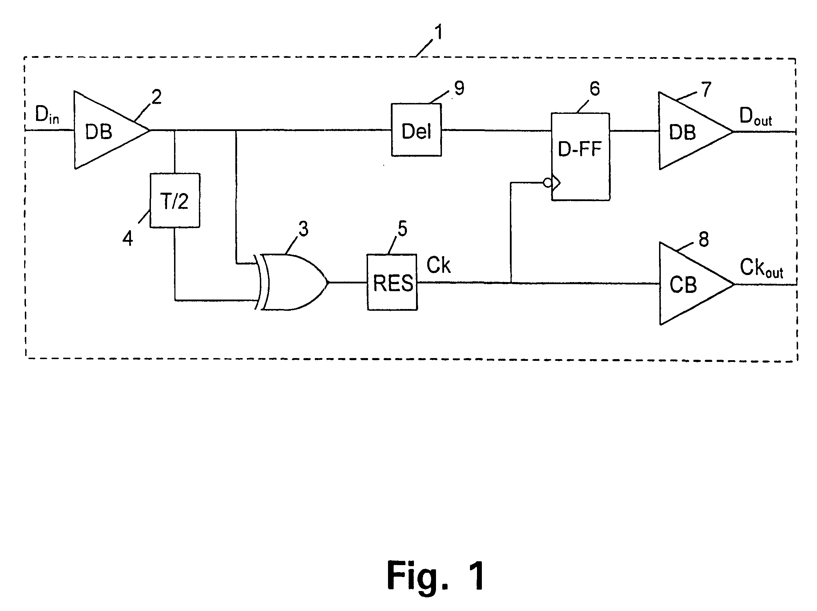

Fig. 1 shows an otherwise known circuit 1 to which the invention may be applied. The circuit shown is a part of a receiver circuit which may receive a digital data signal e.g. from an optical transmission link. Only the data signal itself is transmitted in the optical transmission link and consequently a matching clock signal therefore has to be extracted in the receiver from the received data signal. The incoming data signal Dᵢₙ is led to an XOR circuit 3 via a data buffer 2, partly directly and partly via a delay element 4. If the signal Dᵢₙ is constituted by a data stream of e.g. 2.5 Gbit/s, the bit period T will be 400 ps, and the delay of the delay element 4 may then be T/2 or 200 ps. At the output of the XOR circuit 3 a pulse signal with a pulse of 200 ps will occur for each shift in the data signal. This pulse signal is led to the input of a resonator circuit 5 which e.g. may be a SAW filter or a dielectric high Q filter. The circuit 1 itself will typically be formed as an integrated circuit and the resonance circuit 5 may then optionally be an external component which is coupled to the integrated circuit.

Since the resonance circuit 5 has a very high Q, a stable clock signal Ck of 2.5 GHz will appear at its output, and this clock signal may then be used for sampling the data signal Dᵢₙ in a flip-flop 6 so that a retimed data signal Dₒᵤₜ , i.e. a data signal which is synchronised with the recovered clock signal Ck, will appear at the output of the circuit (via a data buffer 7). Via a clock signal buffer 8 the recovered clock signal is also available as the signal Ckₒᵤₜ at the output of the circuit, said clock signal also being used in following circuits. A delay element 9 is inserted in the transmission path of the received data signal Dᵢₙ from the buffer 2 to the flip-flop 6 for the purpose of compensating for the delay to which the clock signal is inevitably subjected in e.g. the XOR circuit 3 and the resonator circuit 5 so that the sampling in the flip-flop 6 occurs approximately in the centre of the bit period of the data signal.

The delay element 9 may optionally be adjustable to compensate for production tolerances; however, this requires an individual adjustment of every single circuit during production which to a substantial extent makes the product more expensive and more complicated. Since especially the delay in the resonator circuit 5 may furthermore vary to some extent with the temperature, the delay element 9 at the very high data rates, i.e. the very short bit periods, is, however, not able to ensure that the sampling in the flip-flop 6 occurs precisely within the very short time during which the data signal is stable.

US 3,916,084 discloses a system for recovering a digital data signal and a clock signal from a received data signal wherein a clock signal is produced from the received data signal by means of a resonator circuit and wherein the recovered data signal is produced by sampling the received data signal with the recovered signal.

EP 312,671 discloses a predictive clock recovery circuit wherein the clock signal is generated by a phase-locked oscillator.

US 5,793,823 discloses a synchronization circuit in which an internal clock signal is delayed by a delay time to produce delayed clock signals. A delayed clock signal having a rise almost corresponding to an external data signal is used to clock an external data signal.

US 4,339,823 discloses a phase corrected clock recovery circuit for multilevel digital signals.

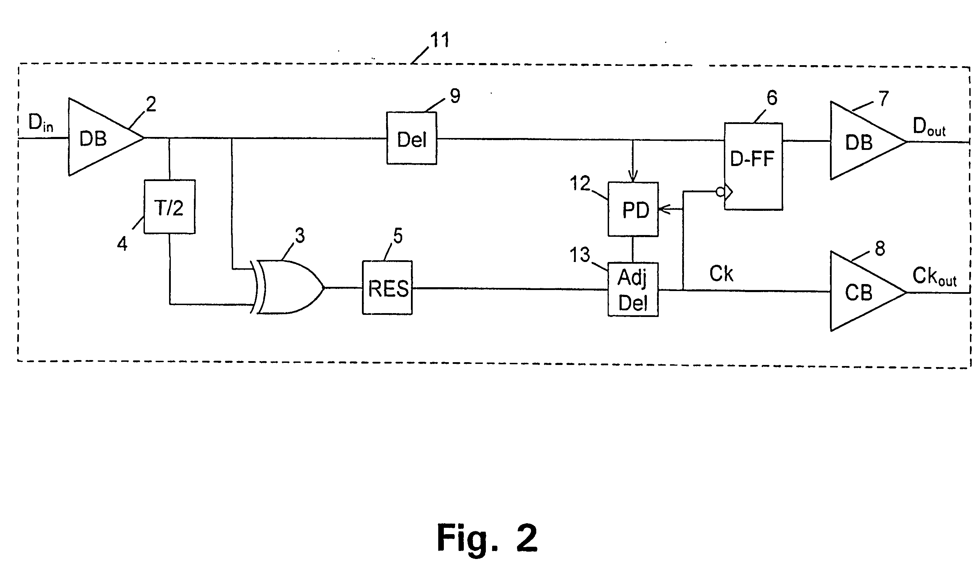

Fig. 2 thus shows a circuit 11 according to the invention wherein this problem is solved. The largest part of the circuit 11 corresponds to the circuit 1 of Fig. 1 and components which are included in both figures also designate the same reference numbers. A phase detector 12, the operation of which will be described in greater detail below, compares the recovered clock signal Ck with the data signal and produces a signal at its output, expressing the phase difference between the two signals and thus between the optimum sampling time and the actual sampling time. The output signal from the resonator circuit 5 is not used directly as the recovered clock signal but is instead led to the input of a controllable delay unit 13 controlled by the output signal from the phase detector 12. The output signal from the delay unit 13 then constitutes the recovered clock signal Ck which has been adjusted now to obtain the optimum sampling time in the flip-flop 6. The circuit 11 also shows a delay unit 9 in the data signal path. The latter may still be appropriate to compensate for the greater delay of the clock signal in the circuit 3 and the resonator circuit 5 since the controllable delay element 13, naturally, provides only positive delays. It should be noted that the delay unit 13 may also in principle consist of a fixed and a controllable delay.

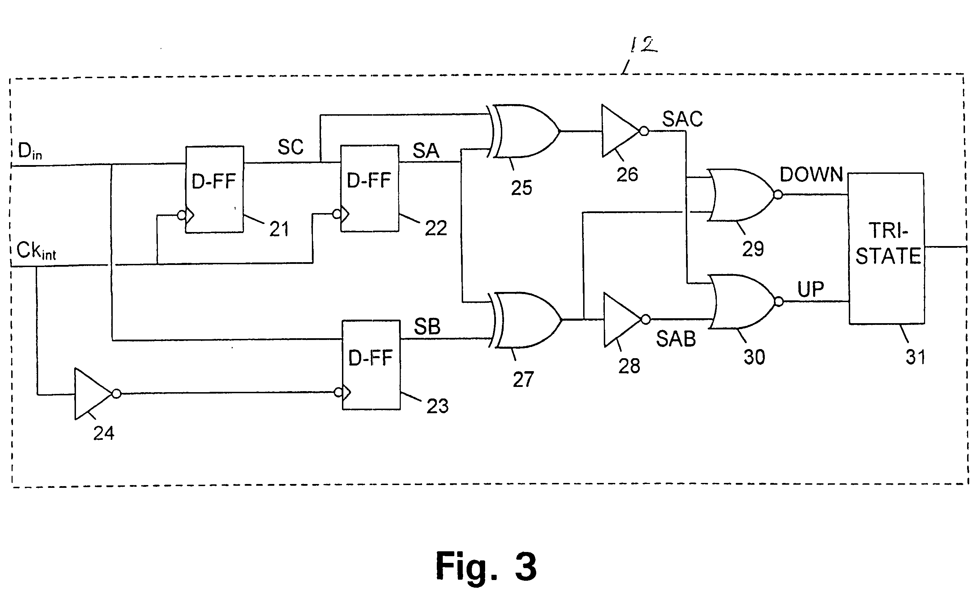

Fig. 3 shows an example of the structure of the phase detector 12. As mentioned above, the phase detector 12 compares the recovered clock signal Ck with the data signal Dᵢₙ and produces a signal at its output, said signal being a measure of the phase difference between the two signals, and thus between the optimum sampling time and the actual sampling time. This is effected by the recovered clock signal Ck being used for sampling the data signal Dᵢₙ in three flip-flops 21, 22, 23 at three different points in time. If the type of flip-flop applied is designed to sample on a positive clock signal edge, the outputs of the two flip-flops 21 and 22 will show the present and preceding sampling value of the data signal, respectively. The present value is called sample C (SC), whereas the preceding value is called sample A (SA). The delay in flip-flop 21 is taken to be sufficient for a new sampling value at the output (SC) caused by a positive clock signal edge not to appear until after flip-flop 22 has performed its sampling caused by said clock signal edge. If this is not the case, an additional delay element between the two flip-flops has to be inserted.

Due to the inverter 24, flip-flop 23 will sample the data signal on the negative edge of the clock signal resulting in a sampling value (sample B, SB) in between the two others, i.e. about that time when the transistion from the preceding to the present bit period occurs, the posititive and negative half periods of the clock signal being taken to be of equal length. If this is not the case, the inverter 24 may be replaced by a delay circuit with a delay corresponding to half a clock signal period.

Thus, at the outputs of the three flip-flops, three successive sampling values will be represented, i.e. SA which was performed approximately in the centre of the preceding bit period, SB which was performed about the time when the transition from the preceding to the present bit period occurs, and SC which was performed approximately in the centre of the present bit period. A signal SAC is produced by means of an XOR circuit 25 and a subsequent inverter 26, said signal being, logically, "1" if the sampling values SA and SC are identical, and being, logically, "0" if they are different, i.e. there has been a shift from the preceding to the present bit period. Similarly, a signal SAB is produced by means of an XOR circuit 27 and a subsequent inverter 28, said signal being, logically, "1" if the sampling values SA and SB are identical, and being, logically, "0" if they are different.

Subsequently, two NOR circuits 29 and 30 produce two signals, UP and DOWN. If SAC is logically "1", corresponding to the sampling values SA and SC being identical, both signals, UP and DOWN, will logically be "0" irrespective of the value of SAB, the sampling value SB being insignificant, since it is impossible, in this situation, to extract information about the position of the sampling time.

If, on the other hand, SAC is logically "0", corresponding to a shift from the preceding to the present bit period having taken place, the signals, UP and DOWN, are determined by the signal SAB. The signal DOWN will logically be "1" if SAB is "1" corresponding to sampling values SA and SB being identical as a result of the shift from the preceding to the present bit period having taken place later than the negative edge of the clock signal. In that case the clock signal is too early compared to the optimum sampling time and the signal DOWN signals that it has to be further delayed. If, on the other hand, SAB is "0", the signal UP will logically be "1", corresponding to the sampling values SA and SB being different as a result of the shift from the preceding to the present bit period having taken place prior to the negative edge of the clock signal. In that case the clock signal is too late compared to the optimum sampling time and the signal UP signals that the delay has to be reduced.

In order to convert the two signals UP and DOWN to a single signal which is led via the filter 12 to the delay element 13, the two signals are led to a tristate circuit or a charge pump 31. When both signals are "0", the output of the circuit 31 is in a state of high impedance (tri-state) so that the delay element 13 is not affected, i.e. the delay is not changed. When the signal UP is, logically, "1", the circuit 31 provides a positive charging current which is led to the delay element 13 and thus increases the control voltage so that the delay is reduced. Similarly, when the signal DOWN is, logically, "1", the circuit 31 provides a negative charging current which is led to the delay element 13 and thus reduces the control voltage so that the delay is increased. Thus, the clock signal Ck will be adjusted continuously in order that sampling B is always performed precisely at the transition time and consequently sampling C in the centre of the bit period.

Further, it should be noted that in the shown circuit the two flip-flops 6 and 21 perform the same function, the signal SC at the output of the flip-flop 21 being identical to the signal constituting the retimed data signal Dₒᵤₜ at the output of the flip-flop 6. One of the two flip-flops may thus be omitted. When two separate flip-flops are mentioned above it is for the purpose of clearness only.

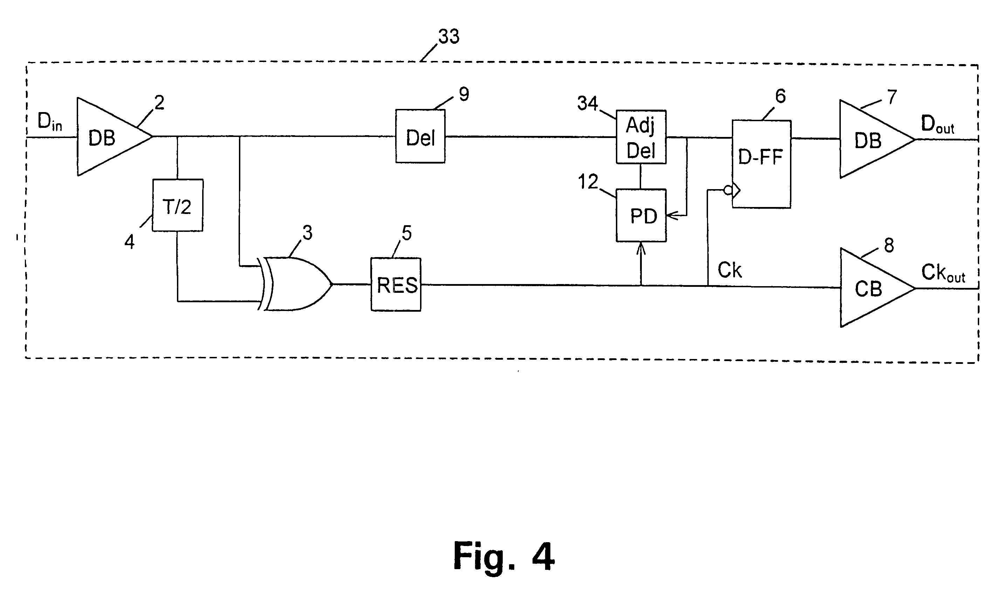

In fig. 2 the controllable delay unit 13 is inserted in the clock signal branch in order that the recovered clock signal is delayed depending on the phase difference measured by the phase detector 12. The crucial point of the invention is, however, simply that the clock signal and the data signal are adjusted with respect to each other whereas it is not crucial whether the clock signal or the data signal is subjected to the variable delay. Thus, in Fig. 4 is shown an alternative embodiment of a circuit 33 according to the invention. Instead of the controllable delay unit 13 in the clock signal branch a controllable delay unit 34 is inserted in the data signal branch. Here, the phase detector 12 compares the recovered clock signal Ck with the delayed data signal and produces, as previously, a signal at its output, said signal being a measure of the phase difference between the two signals, and thus between the optimum sampling time and the actual sampling time. The other parts of the circuit in Fig. 4 are unchanged compared to the circuit in Fig. 2. Further, it should be noted that the fixed delay 9 and the controllable delay unit 34 may optionally be combined in one single unit.

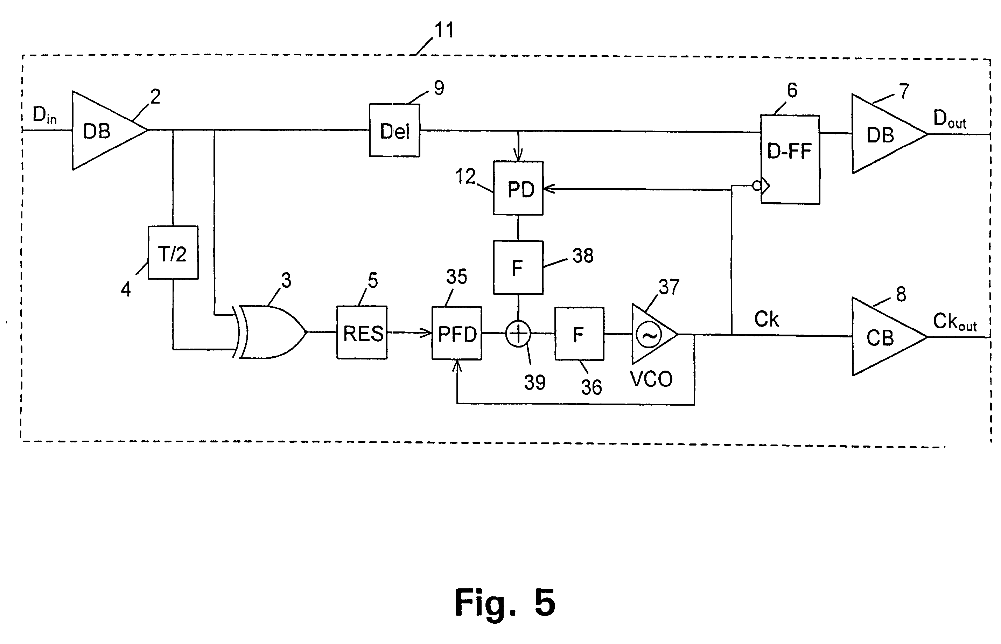

In Figs. 2 and 4 the clock signal and the data signal, respectively, are delayed by means of a controllable delay units 12 and 34, respectively. Fig. 5 shows an embodiment wherein the delay is produced in another manner. The recovered clock signal Ck is here produced by a voltage-controlled oscillator 37 which is frequency locked to the output signal of the resonator circuit 5. The clock signal Ck is led back to a phase frequency detector 35 to be compared with the output signal from the resonator circuit 5. Any frequency difference between the two clock signals will result in an error signal at the output of the phase frequency detector 35, said signal being fed to the voltage-controlled oscillator 37 as a steering signal via a low-pass filter 36.

This contributes to ensuring that the recovered clock signal Ck is frequency locked to the output signal from the resonator circuit 5. However, it does not ensure that the sampling of the data signal in the flip-flop 6 is performed at the appropriate point in time in relation to the data signal. This is achieved when the phase detector 12 compares the recovered clock signal Ck with the data signal and produces a signal at its output, said signal being a measure of the phase difference between the two signals, and thus between the optimum sampling time and the actual sampling time. This offset signal is filtered in the low-pass filter 38 and is then added in the summing point 39 to the error signal from the phase frequency detector 35 before the error signal is fed to the low-pass filter 36 in the original loop. This results in a phase change of the voltage-controlled oscillator 37, and thus of the recovered clock signal. If the time constants for the two filters 36 and 38 are selected so that the low-pass filter 38 is much slower than the low-pass filter 36, the loop consisting of the phase detector 12, the low-pass filters 38 and 36 and the voltage-controlled oscillator 37 will adjust the recovered clock signal Ck to obtain the optimum sampling time in the flip-flop 6. The other parts of the circuit in Fig. 5 are unchanged compared to the circuit in Fig. 2.

For a circuit 11 adapted to operate in the 2.5 GHz range, a time-constant for the low-pass filter 38 of about 100 µS, corresponding to a cut-off frequency of about 10 kHz, such as between 1 KHz and 50 kHz is preferred. As explained above, the time constant of low-pass filter 36 is preferably selected to be significantly smaller the time constant of filter 38, i.e. low-pass filter 36 has, preferably, a substantially higher cut-off frequency than the cut-off frequency of low-pass filter 38. Preferably, the cut-off frequency of low-pass filter 36 is selected as being about 10 - 20 times higher than the cut-off frequency of low-pass filter 38. Accordingly, for operation in the 2.5 GHz range and a selected cut-off frequency of about 10 kHz in low-pass filter 38, a cut-off frequency of about 100 kHz, such as between 40 kHz and 2 MHz should be selected for low-pass filter 36. For higher or lower system operating frequencies, e.g. 10 GHz or 622 MHz (corresponding to STM 64 and STM 4, respectively), these cut-off frequencies are preferably scaled substantially proportionally.

It should be noted that the method of Fig. 5 for production of the time difference may also be applied when the data signal is delayed as in Fig. 4.

Even though preferred embodiments of the present invention have been described and shown, the invention is not limited thereto, but may also be implemented according to other embodiments within the scope of the following claims.

## Claims

1. A method for recovering a digital data signal (Dₒᵤₜ) and a clock signal (CKₒᵤₜ) from a received data signal (Dᵢₙ) consisting of a number of successive bits, wherein a clock signal is first produced from the received data signal by means of a resonator circuit (5), and wherein the recovered data signal is produced by sampling the received data signal with the recovered clock signal, **characterised in that** the received data signal and the recovered clock signal are phase locked to each other by measuring a phase difference between the recovered clock signal and the received data signal and by time delaying one of them depending on this phase difference .

2. A method according to claim 1, **characterised in that** the recovered clock signal is time delayed depending on the measured phase difference.

3. A method according to claim 1, **characterised in that** the received data signal is time delayed depending on the measured phase difference.

4. A method according to claim 2 or 3, **characterised in that** said time delay is produced by applying the measured phase difference as steering signal to a controllable delay unit (13;34).

5. A method according to claim 2 or 3, **characterised in that** said time delay is produced by providing the measured phase difference as a further steering signal to a frequency locked loop, wherein a controlled oscillator (37) produces the recovered clock signal controlled by a signal, said signal being produced as a measure of a frequency variation between the recovered clock signal and an output signal from said resonator circuit.

6. A circuit for recovering a digital data signal (Dₒᵤₜ) and a clock signal (CKₒᵤₜ) from a received data signal (Dᵢₙ) consisting of a number of successive bits, wherein the circuit comprises a resonator circuit (5) for producing a clock signal from the received data signal and is designed to produce the recovered data signal by sampling the received data signal with the recovered clock signal, **characterised by** means (12) for measuring a phase difference between the recovered clock signal and the received data signal and for phase locking the received data signal and the recovered clock signal to each other by time delaying one of them depending on this phase difference.

7. A circuit according to claim 6, **characterised in that** it comprises means (13; 35, 36, 37, 38, 39) for time delaying the recovered clock signal depending on the measured phase difference.

8. A circuit according to claim 6, **characterised in that** it comprises means (34) for time delaying the received data signal depending on the measured phase difference.

9. A circuit according to claim 7 or 8, **characterised in that** it comprises a controllable delay unit (13; 34) designed to produce said time delay controlled by the measured phase difference.

10. A circuit according to claims 7 or 8, **characterised in that** it comprises a frequency locked loop, wherein a controlled oscillator (37) may produce the recovered clock signal controlled by a signal, said signal being produced as a measure of a frequency variation between the recovered clock signal and an output signal from said resonator circuit (5), and wherein the frequency locked loop is furthermore designed to produce said time delay by provision of the measured phase difference as a further steering signal to said loop.

## Patentansprüche

1. Verfahren zur Wiederherstellung eines digitalen Datensignals (Dₒᵤₜ) und eines Taktsignals (CKₒᵤₜ) aus einem empfangenen Datensignal (Dᵢₙ), das eine Reihe aufeinander folgender Bits aufweist, wobei ein Taktsignal zuerst aus dem empfangenen Datensignal durch eine Resonatorschaltung (5) erzeugt wird, und wobei das wiederhergestellte Datensignal durch Abtasten des empfangenen Datensignals mit dem wiederhergestellten Taktsignal erzeugt wird, **dadurch gekennzeichnet, dass** das empfangene Datensignal und das wiederhergestellte Taktsignal durch Messen einer Phasendifferenz zwischen dem wiederhergestellten Taktsignal und dem empfangenen Datensignal und durch zeitliche Verzögerung dieser in Abhängigkeit von der Phasendifferenz miteinander phasenverriegelt sind.

2. Verfahren nach Anspruch 1, **dadurch gekennzeichnet, dass** das wiederhergestellte Taktsignal abhängig von der gemessenen Phasendifferenz zeitlich verzögert wird.

3. Verfahren nach Anspruch 1, **dadurch gekennzeichnet, dass** das empfangene Datensignal abhängig von der gemessenen Phasendifferenz zeitlich verzögert wird.

4. Verfahren nach Anspruch 2 oder 3, **dadurch gekennzeichnet, dass** die genannte zeitliche Verzögerung durch Anwenden der gemessenen Phasendifferenz als Steuersignal einer steuerbaren Verzögerungseinheit (13; 34) zugeführt wird.

5. Verfahren nach Anspruch 2 oder 3, **dadurch gekennzeichnet, dass** die genannte zeitliche Verzögerung durch die Bereitstellung einer gemessenen Phasendifferenz als ein weiteres Steuersignal an eine Frequenzregelschleife erzeugt wird, wobei ein gesteuerter Oszillator (37) das durch ein Signal gesteuerte wiederhergestellte Taktsignal erzeugt, wobei das genannte Signal als ein Maß der Frequenzabweichung zwischen dem wiederhergestellten Taktsignal und einem Ausgangssignal aus der genannten Resonatorschaltung erzeugt wird.

6. Verfahren zur Wiederherstellung eines digitalen Datensignals (Dₒᵤₜ) und eines Taktsignals (CKₒᵤₜ) aus einem empfangenen Datensignal (Dᵢₙ), das eine Reihe aufeinander folgender Bits aufweist, wobei die Schaltung eine Resonatorschaltung (5) zum Erzeugen eines Taktsignals aus dem empfangenen Datensignal umfasst und so gestaltet ist, dass sie das wiederhergestellte Datensignal durch Abtasten des empfangenen Datensignals mit dem wiederhergestellten Taktsignal erzeugt, **gekennzeichnet durch** eine Einrichtung (12) zum Messen einer Phasendifferenz zwischen dem wiederhergestellten Taktsignal und dem empfangenen Datensignal sowie zur Phasenverriegelung des empfangenen Datensignals und des wiederhergestellten Taktsignals miteinander **durch** zeitliche Verzögerung eines der Signale abhängig von der Phasendifferenz.

7. Schaltung nach Anspruch 6, **dadurch gekennzeichnet, dass** sie eine Einrichtung (13; 35, 36, 37, 38, 39) zur zeitlichen Verzögerung des wiederhergestellten Taktsignals abhängig von der gemessenen Phasendifferenz umfasst.

8. Schaltung nach Anspruch 6, **dadurch gekennzeichnet, dass** sie eine Einrichtung (34) zur zeitlichen Verzögerung des empfangenen Datensignals abhängig von der gemessenen Phasendifferenz umfasst.

9. Schaltung nach Anspruch 7 oder 8, **dadurch gekennzeichnet, dass** sie eine steuerbare Verzögerungseinheit (13; 34) umfasst, die so gestaltet ist, dass sie die genannte durch die gemessene Phasendifferenz geregelte zeitliche Verzögerung erzeugt.

10. Schaltung nach Anspruch 7 oder 8, **dadurch gekennzeichnet, dass** sie eine Frequenzregelschleife umfasst, wobei ein gesteuerter Oszillator (37) das durch ein Signal gesteuerte wiederhergestellte Taktsignal erzeugen kann, wobei das genannte Signal als ein Maß einer Frequenzschwankung zwischen dem wiederhergestellten Taktsignal und einem Ausgangssignal von der genannten Resonatorschaltung (5) erzeugt wird, und wobei die Frequenzregelschleife ferner so gestaltet ist, dass sie die genannte zeitliche Verzögerung durch die Bereitstellung der gemessenen Phasendifferenz als ein weiteres Steuersignal für die genannte Schleife erzeugt.

## Revendications

1. Procédé pour récupérer un signal de données numériques (Dₒᵤₜ) et un signal d'horloge (CKₒᵤₜ) depuis un signal de données reçues (Dᵢₙ) composé d'un nombre successif de bits, dans lequel un signal d'horloge est d'abord produit à partir du signal de données reçues au moyen d'un circuit résonateur (5), et dans lequel le signal de données récupérées est produit par un échantillonnage du signal de données reçues avec le signal d'horloge récupéré, **caractérisé en ce que** le signal de données reçues et le signal d'horloge récupéré sont verrouillés en phase l'un par rapport à l'autre en mesurant une différence de phase entre le signal d'horloge récupéré et le signal de données reçues et en retardant l'un des deux en fonction de cette différence de phase.

2. Procédé selon la revendication 1, **caractérisé en ce que** le signal d'horloge obtenu est retardé en fonction de la différence de phase mesurée.

3. Procédé selon la revendication 1, **caractérisé en ce que** le signal de données reçues est retardé en fonction de la différence de phase mesurée.

4. Procédé selon la revendication 2 ou 3, **caractérisé en ce que** ledit retard est produit en appliquant la différence de phase mesurée en tant que signal d'orientation vers une unité (13 ; 34) de retard pouvant être commandée.

5. Procédé selon la revendication 2 ou 3, **caractérisé en ce que** ledit retard est produit par la mise à disposition de la différence de phase mesurée en tant qu'un signal d'orientation supplémentaire vers une boucle verrouillée en fréquence, dans lequel un oscillateur (37) commandé produit le signal d'horloge récupéré commandé par un signal, ledit signal étant produit en tant qu'une mesure d'une variation de fréquence entre le signal d'horloge récupéré et un signal de sortie depuis ledit circuit résonateur.

6. Circuit pour récupérer un signal de données numériques (Dₒᵤₜ) et un signal d' horloge (CKₒᵤₜ) depuis un signal de données reçues (Dᵢₙ) composé d'un nombre successif de bits, dans lequel le circuit comprend un circuit résonateur (5) pour produire un signal d'horloge à partir du signal de données reçues et est conçu pour produire le signal de données récupérées par un échantillonnage du signal de données reçues avec le signal d'horloge récupéré, **caractérisé par** un moyen (12) pour mesurer une différence de phase entre le signal d'horloge récupéré et le signal d'horloge reçu et pour verrouiller en phase le signal de données reçu et le signal d'horloge récupéré l'un par rapport à l'autre en retardant l'un des deux en fonction de cette différence de phase.

7. Circuit selon la revendication 6, **caractérisé en ce qu'**il comprend un moyen (13 ; 35, 36, 37, 38, 39) pour retarder le signal d'horloge récupéré en fonction de la différence de phase mesurée.

8. Circuit selon la revendication 6, **caractérisé en ce qu'**il comprend un moyen (34) pour retarder le signal de données reçues en fonction de la différence de phase mesurée.

9. Circuit selon la revendication 7 ou 8, **caractérisé en ce qu'**il comprend une unité de retard pouvant être commandée (13 ; 34) conçue pour produire ledit retard commandé par la différence de phase mesurée.

10. Circuit selon les revendications 7 ou 8, **caractérisé en ce qu'**il comprend une boucle verrouillée en fréquence, dans lequel un oscillateur (37) commandé peut produire le signal d'horloge récupéré commandé par un signal, ledit signal étant produit en tant qu'une mesure d'une variation de fréquences entre le signal d'horloge récupéré et un signal de sortie depuis le circuit résonateur (5), et dans lequel la boucle verrouillée en fréquence est par ailleurs conçue pour produire ledit retard par la mise à disposition de la différence de phase mesurée en tant qu'un signal d'orientation supplémentaire vers ladite boucle.
